(19) **Europäisches Patentamt / European Patent Office / Office européen des brevets**

(11) **EP 1 983 678 A2**

(12) ## EUROPEAN PATENT APPLICATION

(43) Date of publication:
**22.10.2008 Bulletin 2008/43**

(51) Int Cl.:
*H04L 1/00* (2006.01)

(21) Application number: **08103635.2**

(22) Date of filing: **21.04.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **19.04.2007 KR 20070038308**

(71) Applicant: **LG Electronics Inc.**
**Seoul 150-721 (KR)**

(72) Inventors:
- **Ko, Woo Suk**
  **137-724 SEOUL (KR)**
- **Moon, Sang Chul**
  **137-724 SEOUL (KR)**

(74) Representative: **Cabinet Plasseraud**
**52 rue de la Victoire**
**75440 Paris Cedex 09 (FR)**

(54) **Method of transmitting and receiving a signal and apparatus for transmitting and receiving a signal**

(57) A method of transmitting/receiving a signal and an apparatus for transmitting/receiving a signal are disclosed. The method of transmitting the signal includes performing FEC-encoding with respect to input data according to a plurality of channel coding methods, interleaving the FEC-encoded data and converting the interleaved data into symbol data. Accordingly, it is possible to facilitate the switching of a signal transmitting/receiving system using the existing signal transmitting/receiving network, improve a data transfer rate, and increase a signal transmission distance. Accordingly, it is possible to improve the signal transmission/reception performance of the transmitting/receiving system.

EP 1 983 678 A2

## Description

This application claims the benefit of Korean Patent Application No. 10-2007-0038308, filed on April 19, 2007.

## BACKGROUND OF THE INVENTION

### Field of the Invention

The present invention relates to a method of transmitting/receiving a signal and an apparatus for transmitting/receiving a signal, and more particularly to a method of transmitting/receiving a signal and an apparatus for transmitting/receiving a signal, which are capable of increasing a data transfer rate.

### Discussion of the Related Art

As a digital broadcasting technology has been developed, a broadcasting signal including a high definition (HD) moving image and high-quality digital sound can be transmitted/received. With continuous development of a compression algorithm and high performance of hardware, a digital broadcasting system has been rapidly developed. A digital television (DTV) system can receive a digital broadcasting signal and provide a variety of supplementary services to users as well as a video signal and an audio signal.

As a digital broadcast has come into wide use, a demand for a service such as a more excellent video and audio signal has been increased and the size of data or the number of broadcasting channels, which are desired by users, has been gradually increased.

However, in the existing method of transmitting/receiving a signal, the quantity of transmitted/received data or the number of broadcasting channels cannot be increased. Accordingly, there is a need for a new method of transmitting/receiving a signal, which is capable of improving channel bandwidth efficiency and reducing cost consumed for constructing a network for transmitting/receiving the signal, compared with the existing method of transmitting/receiving the signal.

## SUMMARY OF THE INVENTION

Accordingly, the present invention is directed to a method of transmitting/receiving a signal and an apparatus for transmitting/receiving a signal that substantially obviate one or more problems due to limitations and disadvantages of the related art.

An object of the present invention devised to solve the problem lies on a method of transmitting/receiving a signal and an apparatus for transmitting/receiving a signal, which are capable of increasing a data transfer rate and using the existing network for transmitting/receiving the signal.

To achieve these objects and other advantages and in accordance with the purpose of the invention, as embodied and broadly described herein, there are provided an apparatus for transmitting a signal and an apparatus for receiving a signal. The apparatus for transmitting a signal includes a forward error correction (FEC) encoder, a first interleaver, a symbol mapper, a second interleaver, an encoder, a pilot symbol inserter, and a transmitter.

The forward error correction (FEC) encoder performs forward error correction (FEC) encoding with respect to input data according to a Bose-chaudhuri-Hocquenghem (BCH) coding scheme and a low density parity check (LDPC) coding scheme. The first interleaver interleaves the FEC-encoded data, the symbol mapper converts the interleaved data into data symbols, and a second interleaver interleaves the data symbols. An encoder encodes the data symbols interleaved by the second interleaver. The pilot symbol inserter inserts at least one pilot symbol into a data frame including the encoded data symbols and The transmitter transmits the data frame including the pilot symbols and the data symbols.

The pilot symbol inserter inserts the at least one pilot symbol in a beginning portion in the data frame. The second interleaver stores the converted data symbols in a memory in a row direction and reads the stored data symbols in a column direction.

The encoder receives consecutive first and second symbols and encodes the symbols such that $Y\_tx1\ (t) = S0$, $Y\_tx1\ (t+T) = S1$, $Y\_tx2\ (t) = -S1^*$, and $Y\_tx2\ (t+T) = S0^*$, where S0 represents the first symbol, S1 represents the second symbol, * represents a complex conjugate, $Y\_tx1$ represents the encoded symbols to be transmitted through a first antenna, $Y\_tx2$ represents the encoded symbols to be transmitted through a second antenna, t represents a time at which the symbols are transmitted, and T represents a time period between which the first symbol and the second symbol are transmitted respectively.

And the apparatus for receiving a signal includes a receiver, a frame parser (1330), a decoder, a first deinterleaver, a symbol demapper, a second deinterleaver and a forward error correction (FEC) decoder.

The frame parser parses the data symbols from the received data frame, The decoder decodes the parsed data symbols. And the first deinterleaver deinterleaves the decoded data symbols, The symbol demapper converts the deinterleaved data symbols into bit data and the second deinterleaver deinterleaves the converted bit data. And the forward error correction (FEC) decoder performs forward error correction (FEC) decoding with respect to the deinterleaved bit data according to a Bose-chaudhuri-Hocquenghem (BCH) decoding scheme and a low density parity check (LDPC) decoding scheme.

The at least one pilot symbol may be included in a beginning portion of the data frame. The decoder decodes the parsed data symbols according to an Alamouti algorithm. The first deinterleaver stores the decoded data symbols in a memory in a row direction and reads the stored data symbols in a column direction.

In another aspect, there are provided a method of transmitting and receiving a signal. The method includes performing forward error correction (FEC) encoding with respect to input data according to a Bose-chaudhuri-Hocquenghem (BCH) coding scheme and a low density parity check (LDPC) coding scheme, interleaving the FEC-encoded data, converting the interleaved data into data symbols, interleaving the data symbols, encoding the interleaved data symbols, inserting at least one pilot symbol into a data frame including the encoded data symbols and transmitting the data frame including the pilot symbols and the data symbols.

The converted data symbols are interleaved in a manner that the converted data symbols are stored in a memory in a row direction and the stored data symbols are read in a column direction.

In the encoding of the interleaved data symbols, first and second symbols in the interleaved data symbols are encoded such that $Y\_tx1 (t) = S0$, $Y\_tx1 (t+T) = S1$, $Y\_tx2 (t) = -S1^*$, $Y\_tx2 (t+T) = S0^*$, where S0 represents the first symbol, S1 represents the second symbol, * represents a complex conjugate, Y_tx1 represents the encoded symbols to be transmitted through a first antenna, Y_tx2 represents the encoded symbols to be transmitted through a second antenna, t represents a time at which the symbols are transmitted, and T represents a time period between which the first symbol and the second symbol are transmitted respectively.

The method includes receiving a data frame including data symbols and at least one pilot symbol, parsing the data symbols from the received data frame, decoding the parsed data symbols, deinterleaving the decoded data symbols, converting the deinterleaved data symbols into bit data, deinterleaving the converted bit data and performing forward error correction (FEC) decoding with respect to the deinterleaved bit data according to a Bose-chaudhuri-Hocquenghem (BCH) decoding scheme and a low density parity check (LDPC) decoding scheme.

The parsed data symbols are decoded according to an Alamouti algorithm. The decoded data symbols are interleaved in an manner that the decoded data symbols are stored in a memory in a row direction and the stored data symbols are read in a column direction.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

It is to be understood that both the foregoing general description and the following detailed description of the present invention are exemplary and explanatory and are intended to provide further explanation of the invention as claimed.

## BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

FIG. 1 is a schematic block diagram showing an apparatus for transmitting a signal according to an embodiment of the present invention;

FIG. 2 is a schematic block diagram showing a forward error correction encoder according to an embodiment of the present invention;

FIG. 3 is a view showing an interleaver for interleaving input data according to an embodiment of the present invention;

FIG. 4 is a schematic block diagram showing a trellis coded modulator according to an embodiment of the present invention;

FIG. 5 is a schematic block diagram showing a linear pre-coder according to an embodiment of the present invention;

FIGs. 6 to 8 are views showing a code matrix for dispersing input data according to an embodiment of the present invention;

FIG. 9 is a view showing a structure of a transfer frame according to an embodiment of the present invention;

FIG. 10 is a block diagram showing a signal transmitting apparatus having a plurality of transmission paths

according to another embodiment of the present invention;

FIGs. 11 to 15 are views showing an example of a 2x2 code matrix for dispersing input symbols according to an embodiment of the present invention;

FIG. 16 is a view showing an example of an interleaving method according to an embodiment of the present invention;

FIG. 17 is a view showing a detailed example of the interleaving method of FIG. 16 according to an embodiment of the present invention;

FIG. 18 is a view showing an example of a multi-input/output encoding method according to an embodiment of the present invention;

FIG. 19 is a view showing a structure of a pilot symbol interval according to an embodiment of the present invention;

FIG. 20 is a view showing another structure of the pilot symbol interval according to an embodiment of the present invention;

FIG. 21 is a schematic block diagram showing an apparatus for receiving a signal according to an embodiment of the present invention;

FIG. 22 is a schematic block diagram showing an example of a linear pre-coding decoder according to an embodiment of the present invention;

FIG. 23 is a schematic block diagram showing another example of the linear pre-coding decoder according to an embodiment of the present invention;

FIGs. 24 to 26 are views showing examples of a 2x2 code matrix for restoring the dispersed symbols according to an embodiment of the present invention;

FIG. 27 is a schematic block diagram showing a trellis coded modulation decoder according to an embodiment of the present invention;

FIG. 28 is a schematic block diagram showing a forward error correction decoder according to an embodiment of the present invention;

FIG. 29 is a block diagram showing an example of a signal receiving apparatus having a plurality of reception paths according to an embodiment of the present invention;

FIG. 30 is a view showing an example of a multi-input/output decoding method according to an embodiment of the present invention;

FIG. 31 is a view showing a detailed example of FIG. 30 according to an embodiment of the present invention;

FIG. 32 is a schematic block diagram showing another example of the apparatus for transmitting the signal according to an embodiment of the present invention;

FIG. 33 is a schematic block diagram showing another example of the apparatus for receiving the signal according to an embodiment of the present invention;

FIG. 34 is a flowchart illustrating a method of transmitting a signal according to an embodiment of the present invention; and

FIG. 35 is a flowchart illustrating a method of receiving a signal according to an embodiment of the present invention.

## DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

A method of transmitting/receiving a signal and an apparatus for transmitting/receiving a signal according to the present invention will be described in detail with reference to the accompanying drawings.

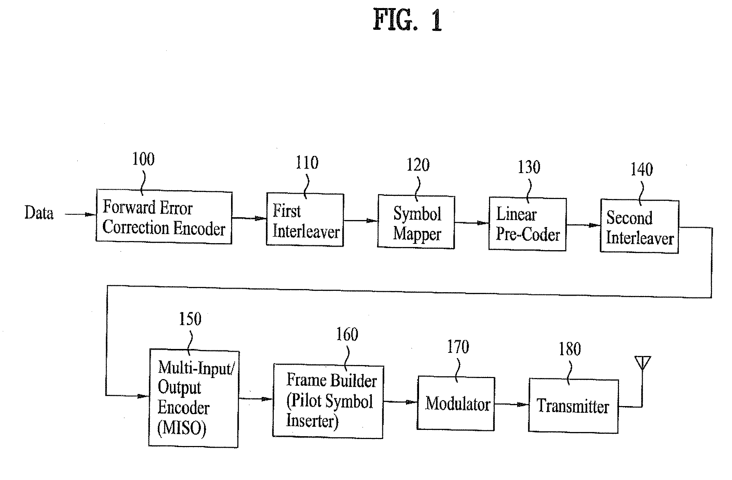

FIG. 1 is a schematic block diagram showing an apparatus for transmitting a signal according to an embodiment of the present invention.

The apparatus for transmitting the signal of FIG. 1 may be a broadcasting signal transmitting system for transmitting a broadcasting signal including video data and so on. In FIG. 1, for example, a signal transmitting system according to a digital video broadcasting (DVB) system will now be described. In the embodiment of FIG. 1, the signal transmitting system will be described, concentrating on an operation for processing a signal.

The embodiment of FIG. 1 includes a forward error correction (FEC) encoder 100, a first interleaver 110, a symbol mapper 120, a linear pre-coder 130, a second interleaver 140, a multi-input/output encoder 150, a frame builder 160, a modulator 170 and a transmitter 180.

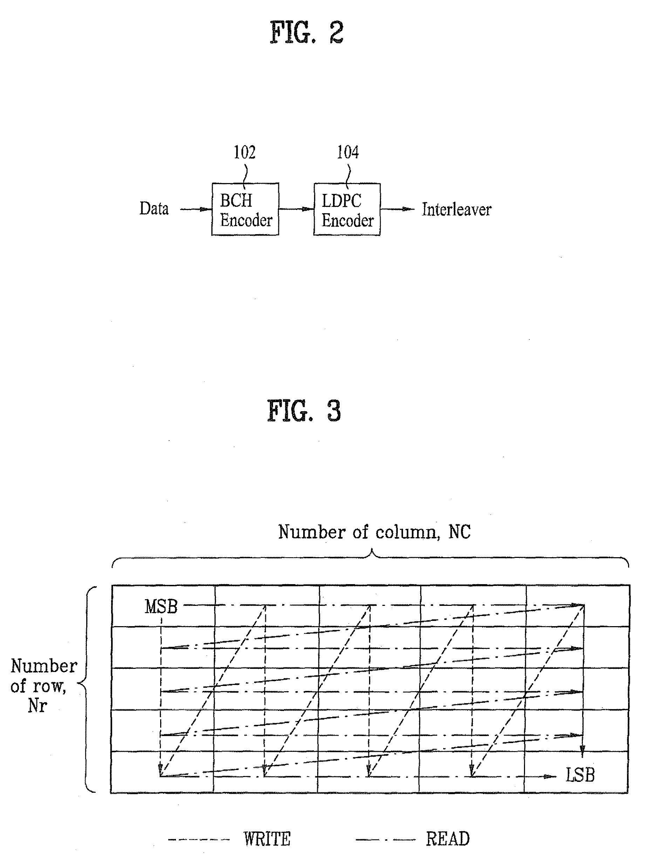

The FEC encoder 100 encodes an input signal and outputs the encoded signal. The FEC encoder 100 makes it possible for a signal receiving system to detect an error which occurs in transmitted data, and correct the error. The data encoded by the FEC encoder 100 is input to the first interleaver 110. A detailed example of the FEC encoder 100 is shown in FIG. 2.

The first interleaver 110 shuffles the data output from the FEC encoder 100 at random positions so as to become robust against a burst error which occurs in the data when transmitting the data. The first interleaver 110 can use a convolution interleaver or a block interleaver, which may be changed according to the transmitting system. The embodiment of the first interleaver 110 is shown in FIG. 3 in detail.

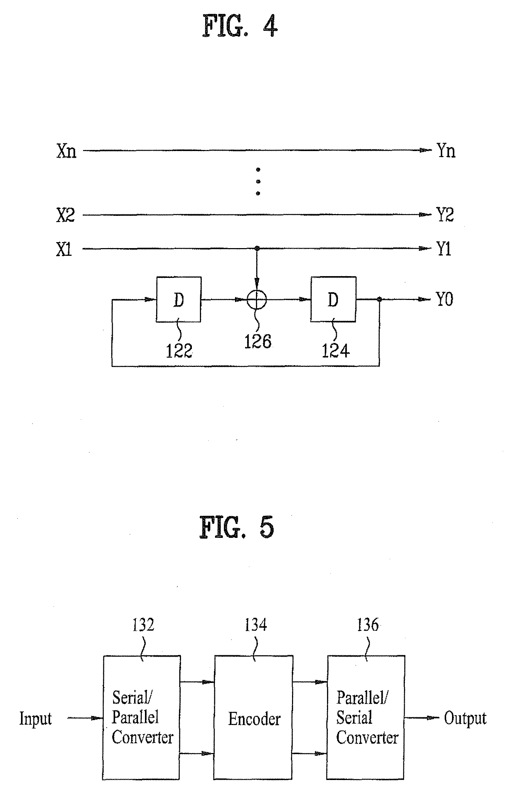

The data interleaved by the first interleaver 110 is input to the symbol mappper 120. The symbol mappper 120 may be trellis coded modulator, hereinafter, when the symbol mappper 120 maps data to symbol according to trellis coded modulation. The trellis coded modulator 120 converts the input data into coded symbol data. The trellis coded modulator 120 may code a transmission signal and may be a symbol mapper mapping the coded signal to a symbol according to a scheme such as a QAM scheme or a QPSK scheme. A detailed example of the trellis coded modulator 120 is shown in FIG. 4.

The linear pre-coder 130 disperses input symbol data into several pieces of output symbol data so as to decrease a probability that all information is lost due to fading when being subjected to frequency selective fading of a channel. A detailed example of the linear pre-coder 130 is shown in FIGs. 5 to 8.

The second interleaver 140 interleaves the symbol data output from the linear pre-coder 130. That is, if the interleaving is performed by the second interleaver 140, an error which occurs when the symbol data is subjected to the same frequency selective fading at a specific position can be corrected. The second interleaver 140 may use a convolution interleaver or a block interleaver. The embodiment of the second interleaver 110 is also shown in FIG. 3 in detail.

The linear pre-coder 130 and the second interleaver 140 process data to be transmitted so as to become robust against the frequency selective fading of the channel and may be called a frequency selective fading coder.

The multi-input/output encoder 150 encodes the data interleaved by the second interleaver 140 such that the data is processed via a plurality of transmission paths. The apparatus for transmitting/receiving the signal can process the signal according to the multi-input/output method. Hereinafter, the multi-input/output method includes the multi-input multi-output (MIMO) method, a single-input multi-output (SIMO) and a multi-input single-output (MISO) method.

As the multi-input/output encoding method, a spatial multiplexing method and a spatial diversity method can be used. In the spatial multiplexing method, data having different information are simultaneously transmitted using multiple antennas of a transmitter and a receiver. Accordingly, the data can be more rapidly transmitted without further increasing the bandwidth of the system. In the spatial diversity method, data having the same information is transmitted via multiple transmission antennas such that diversity effect can be obtained.

At this time, as the multi-input/output encoder 150 using the spatial diversity method, a space-time block code (STBC), a space-frequency block code (SFBC) or a space-time trellis code (STTC) may be used. As the multi-input/output encoder 150 using the spatial multiplexing method, a method of dividing a data stream by the number of transmission antennas and transmitting the data stream, a full-diversity full-rate (FDFR) code, a linear dispersion code (LDC), a vertical-bell lab layered space-time (VBLAST) or a diagonal-BLAST (D-BLAST) may be used.

The frame builder 160 inserts the pre-coded signal into a pilot signal at a predetermined position of a frame and builds a frame defined in the transmitting/receiving system. The frame builder 160 may place a data symbol interval and a pilot symbol interval, which is a preamble of the data symbol interval, in the frame. Accordingly, hereinafter the frame builder 160 may be called a pilot symbol inserter.

For example, the frame builder 160 may place pilot carriers, of which positions are temporally shifted and dispersed, in a data carrier interval. The frame builder may place continuation pilot carriers, of which positions are temporally fixed, in the data carrier interval.

The modulator 170 modulates the data by an orthogonal frequency division multiplex (OFDM) method such that OFDM symbols are generated. And the modulator 170 inserts a guard interval into the modulated data.

The transmitter 180 converts the digital signal having the guard interval and the data interval, which is output from the modulator 170, into an analog signal and transmits the analog signal.

FIG. 2 is a schematic block diagram showing the FEC encoder shown in FIG. 1. The FEC encoder includes a Bose-chaudhuri-Hocquenghem (BCH) encoder 102 and a low density parity check (LDPC) encoder 104 as an outer encoder and an inner encoder, respectively.

A LDPC code is an error correction code which can reduce a probability that data information is lost. The LDPC encoder 104 encodes the signal in a state in which the length of an encoding block is large such that the transmitted data is robust against a transmission error. In order to prevent hardware complexity from being increased due to the increase of the block size, the density of the parity bit is decreased so as to decrease the complexity of the encoder.

In order to prevent an error floor from occurring in the output data of the receiver, the BCH encoder 102 is concatenated in front of the LDPC encoder 104 as the additional outer encoder. If an ignorable error floor occurs even when only the LDPC encoder 104 is used, the BCH encoder 102 may not be used. Alternatively, other encoders may be used as the outer encoder, instead of the BCH encoder.

In the case that the two error correction encoders are used, parity check bits (BCH parity check bits) for the BCH encoding are added to the input data frame and parity check bits (LDPC parity check bits) for the LDPC encoding is added to the BCH parity check bits. The length of the BCH parity check bits added to the encoded data frame may vary according to the length of a LDPC codeword and a LDPC code rate.

The data which is FEC-encoded by the BCH encoder 102 and the LDPC encoder 104 is output to the first interleaver 110.

FIG. 3 is a view showing the first (second) interleaver shown in FIG. 1. As the first (second) interleaver of FIG. 3, for example, a block interleaver may be used.

The interleaver of FIG. 3 stores input data in a matrix-shaped memory space in a predetermined pattern and reads and outputs the data in a pattern different from the pattern used for storing the data. For example, the interleaver of FIG. 3 has an Nr×Nc memory space composed of Nr rows and Nc columns and the data input to the interleaver is filled from a position corresponding to a first row and a first column of the memory space. The data is stored from the first row and the first column to an Nr$^{th}$ row and the first column and, if the first column is filled up, is then stored from the first row to the Nr$^{th}$ row of a next column (second column). In this sequence, the data may be stored up to the Nr$^{th}$ row of an Nc$^{th}$ column (i.e. the data are stored column-wise).

In the case that the data stored as shown in FIG. 3 is read, the data is read and output from the first row and the first column to the first row and the Nc$^{th}$ column. If all the data of the first row is read, the data is read and output from the first column of a next row (second row) in the column direction. The data may be read and output up to the Nc$^{th}$ column of the Nr$^{th}$ row in this sequence (i.e. the data are read out row-wise). At this time, the position of a most significant bit (MSB) of the data block is a left uppermost side and the position of a least significant bit (LSB) thereof is a right lowermost side.

The size of the memory block, the storage pattern and the read pattern of the interleaver are only exemplary and may be changed according to implementation embodiments. For example, the size of the memory block of the first interleaver may vary according to the size of the FEC-encoding block. In the example of FIG. 2, the sizes of the row Nr and the column Nc of the block, which decide the size of the block interleaved by the first interleaver, may vary according to the length of the LDPC code block. If the length of the LDPC code block is increased, the length of the block (e.g., the length of the row of the block) may be increased.

FIG. 4 is a schematic block diagram showing the trellis coded modulator. The trellis coded modulation is a symbol mapping method in which a minimum Euclidean distance of symbols can be maximized. The trellis coded modulator 120 includes a delay element and a bitwise operator. In FIG. 4, for convenience of description, for example, two delay elements (a first delay element 122 and a second delay element 124) and a bitwise adder 126 are used. That is, the number of the delay elements and the bitwise operators may vary according to the number of states or the number of input bits to be trellis-coded. The trellis coded modulator 120 receives input bits X1 to Xn and outputs n (Y1 to Yn) MSBs via a regular code path. The trellis coded modulator receives input LSB X1 and outputs an output Y1 and an additional bit Yo which is trellis-encoded.

The bitwise adder 126 bitwise adds the input value X1 and the value output from the first delay element 122 and outputs the added value. The second delay element 124 delays the value output from the bitwise adder 126 and outputs Y0. The value output from the second delay element 124 feeds back to the first delay element 122.

Among the output bits Y0 to Yn, Y1 and Y0 are used for selecting a coset which is a subset in Trellis Coded Modulation encoded constellation and the remaining bits Y2 to Yn are used for determining the constellation in the coset.

The trellis coded modulator 120 can reduce errors of bits for selecting the coset when the number of states is increased or the number of input bits to be trellis-coded is increased.

The linear pre-coder 130 disperses the input symbol data into several pieces of output symbol data so as to reduce a probability that all information is lost due to fading when being subjected to the frequency selective fading channel.

FIG. 5 is a schematic block diagram showing the linear pre-coder of FIG. 1. The linear pre-coder 130 may include a serial/parallel converter 132, an encoder 134 and a parallel/serial converter 136.

The serial/parallel converter 132 converts the input data into parallel data. The encoder 134 disperses the values of the converted parallel data into several pieces of data via the operation of an encoding matrix.

An encoding matrix is designed by comparing an transmission symbol with an reception symbol such that a pairwise error probability (PEP) that the two symbols are different from each other is minimized. If the encoding matrix is designed such that the PEP is minimized, a diversity gain and a coding gain obtained via the linear pre-coding are maximized.

If a minimum Euclidean distance of the linearly pre-coded symbol is maximized via the encoding matrix, an error probability can be minimized when the receiver uses a maximum likelihood (ML) decoder.

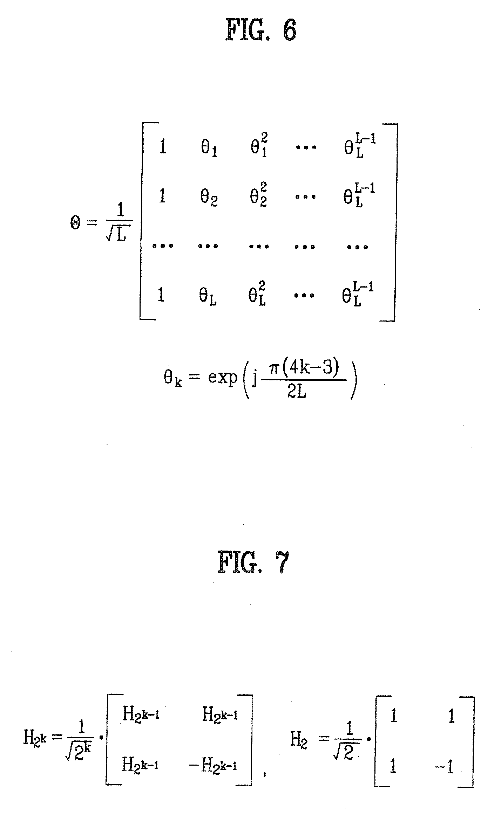

FIG. 6 is a view showing an example of the encoding matrix used by the encoder 134, that is, a code matrix for dispersing input data. FIG. 6 shows an example of the encoding matrix for dispersing the input data into several pieces of output data, which is also called a vanderMonde matrix.

The input data may be arranged in parallel by the length of the number (L) of output data.

θ of the matrix may be expressed by the following equation and may be defined by other methods. If the vanderMonde matrix is used as the encoding matrix, a matrix element may be determined according to Equation 1.

The encoding matrix of Equation 1 rotates the input data by the phase of Equation 1 corresponding to input data and generates the output data. Accordingly, the values input according to the characteristics of the matrix of the linear pre-coder may be dispersed in at least two output values.

[Equation 1]

$$\theta_k = \exp(j\frac{\pi(4k-3)}{2L}, k = 1,2,3,\cdots$$

In Equation 1, L denotes the number of the output data. If an input data group input to the encoder of FIG. 5 is x and a data group which is encoded and output by the encoder 134 using the matrix of Equation 1 is y, y is expressed by Equation 2.

[Equation 2]

$$Y=\Theta x$$

FIG. 7 shows another example of the encoding matrix. FIG. 7 shows another example of the encoding matrix for dispersing the input data into several pieces of output data, which is also called a Hadamard matrix. The matrix of FIG. 7 is a matrix having a general form, in which L is expanded by $2^k$. Here, L denotes the number of output symbols into which the input symbols will be dispersed.

The output symbols of the matrix of FIG. 7 can be obtained by a sum and a difference among L input symbols. In other words, the input symbols may be dispersed into the L output symbols, respectively.

Even in the matrix of FIG. 7, if an input data group input to the encoder 134 of FIG. 5 is x and a data group which is encoded and output by the encoder 134 using the above-described matrix is y, y is a product of the above-described matrix and x.

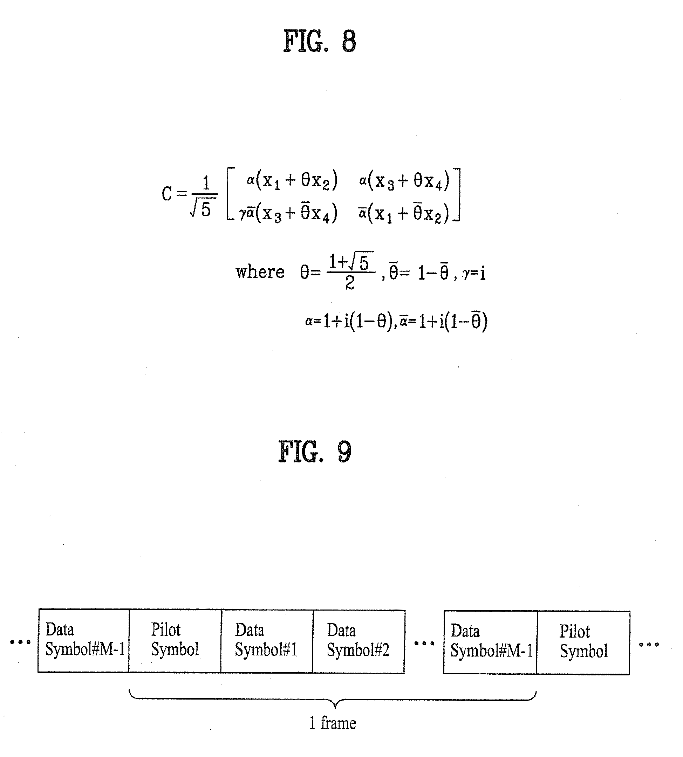

FIG. 8 shows another example of the encoding matrix for dispersing the input data. FIG. 8 shows another example of the encoding matrix for dispersing the input data into several pieces of output data, which is also called a Golden code. The Golden code is a $4\times4$ matrix having a special form. Alternatively, two different $2\times2$ matrixes may be alternately used.

C of FIG. 8 denotes a code matrix of the Golden code and x1, x2, x3 and x4 in the code matrix denote symbol data which can be input to the encoder 134 of FIG. 5 in parallel. Constants in the code matrix may decide the characteristics of the code matrix, and the values of the rows and the columns computed by the constants of the code matrix and the input symbol data may be expressed by the output symbol data. The output sequence of the symbol data may vary according to the implementation embodiments. Accordingly, in this case, the parallel/serial converter 136 of FIG. 5 may convert the parallel data into the serial data according to the position sequence of the data in a parallel data set output from the encoder 134 and output the serial data.

FIG. 9 is a view showing a structure of a transfer frame of the data channel-coded by the above-described embodiment. The transfer frame formed according to the present embodiment may include a pilot symbol including pilot carrier information and a data symbol including data information.

In the example of FIG. 9, a frame includes M (M is a natural number) intervals and is divided into M-1 data symbol intervals and a pilot symbol interval which is used as a preamble. The frame having the above-described structure is repeated.

Each symbol interval includes carrier information by the number of OFDM subcarriers. The pilot carrier information of the pilot symbol interval is composed of random data in order to decrease a peak-to-average power ratio (PAPR). An auto-correlation value of the pilot carrier information has an impulse shape in a frequency domain. The correlation value between file carrier symbols may be close to 0.

Accordingly, the pilot symbol interval used as the preamble allows the receiver to quickly recognize the signal frame of FIG. 9 and may be used for correcting and synchronizing a frequency offset. Since the pilot symbol interval represents the start of the signal frame, a system transmission parameter for allowing the received signal to be quickly synchronized may be set. The frame builder builds the data symbol intervals and inserts the pilot symbol interval in front of the data symbol intervals, thereby building a transfer frame.

If a separate interval including the pilot carrier information is present in the transfer frame as shown in FIG. 9, the pilot carrier information may not be included in the data symbol intervals. Accordingly, it is possible to increase a data capacity. In the DVB, for example, since a percentage of pilot carriers in all the valid carriers is about 10%, the increasing rate of the data capacity is expressed by Equation 3.

[Equation 3]

$$\Delta = 100 \times (\frac{1}{10} - \frac{1}{M})\%$$

In Equation 3, $\Delta$ denotes the increasing rate and M denotes the number of intervals included in a frame.

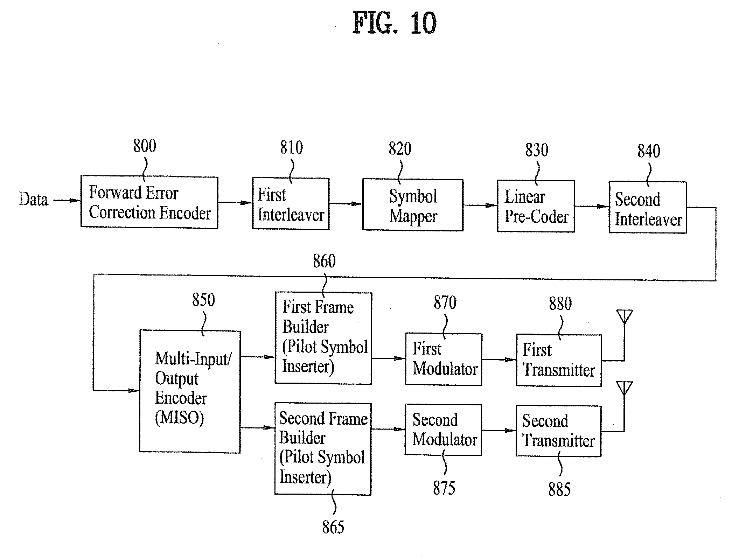

FIG. 10 is a block diagram showing a signal transmitting apparatus, which processes signals using a plurality of transmission paths, according to another embodiment of the present invention. Hereinafter, convenience of description, it is assumed that the number of transmission paths is two.

The embodiment of FIG. 10 includes a forward error correction (FEC) encoder 800, a first interleaver 810, a symbol mapper (a trellis coded modulator) 820, a linear pre-coder 830, a second interleaver 840, a multi-input/output encoder 850, a first frame builder 860, a second frame builder 865, a first modulator 870, a second modulator 875, a first transmitter 880, and a second transmitter 885.

The FEC encoder 800, the first interleaver 810, the linear pre-coder 830, the second interleaver 840, and the multi-input/output encoder 850 perform the same functions as those of FIG. 1.

The FEC encoder 800 includes a BCH encoder and a LDPC encoder. The FEC encoder 800 FEC-encodes input data and outputs the encoded data. The output data is interleaved by the first interleaver 810 such that the sequence of the data stream is changed. As the first interleaver 810, a convolution interleaver or a block interleaver may be used.

The trellis coded modulator 820 may convert the input data into coded symbol data. That is, the trellis coded modulator 820 may code a transmission signal and map the coded signal to a symbol according to the QAM or QPSK scheme. For example, if the signal is mapped to the symbol to generate 128QAM, 7-bit data may be included in a symbol and, if the signal is mapped to the symbol to generate 256QAM, 8-bit data may be included in a symbol.

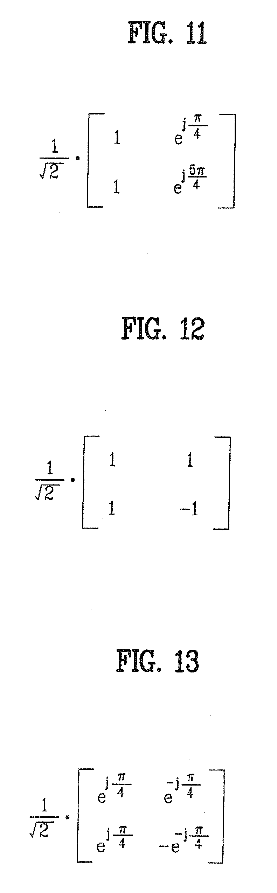

The linear pre-coder 830 includes a serial/parallel converter, an encoder and a parallel/serial converter. A code matrix encoded by the linear pre-coder 830 is shown in FIGs. 11 to 15.

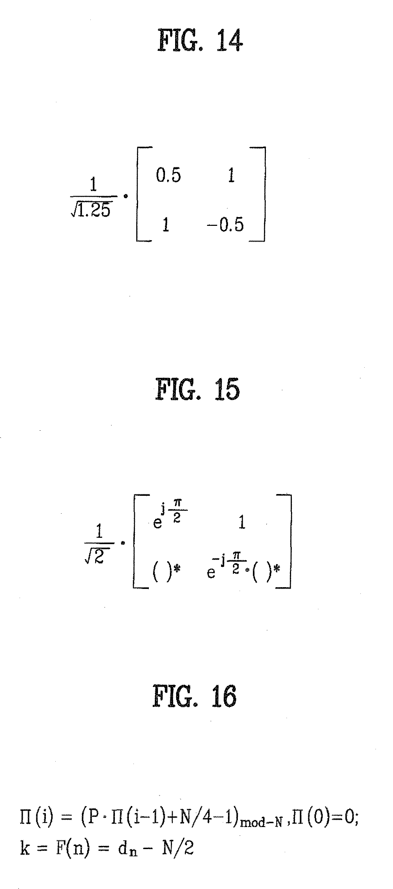

The second interleaver 840 interleaves the symbol data output from the linear pre-coder 830. As the second interlever 840, a convolution interleaver or a block interleaver may be used. The second interleaver 840 interleaves the symbol data such that the symbol data which is dispersed into the data output from the linear pre-coder 830 is not subjected to the same frequency selective fading. The interleaving method may vary according to the implementation embodiments. An example of the interleaving method is shown in FIGs. 16 to 17.

The interleaved data is output to the multi-input/output encoder 850 and the multi-input/output encoder 850 encodes the input symbol data and outputs the encoded data such that the data is transmitted via a plurality of transmission antennas. For example, if two transmission paths exist, the multi-input/output encoder 850 outputs the pre-coded data to the first frame builder 860 or the second frame builder 865.

In a spatial diversity method, the data having the same information is output to the first frame builder 860 and the second frame builder 865. If the encoding is performed by the spatial multiplexing method, different data is output to the first frame builder 860 and the second frame builder 865.

The first frame builder 860 and the second frame builder 865 build frames, into which the pilot signals are inserted, such that the received signals are modulated by the OFDM method.

The first modulator 870 and the second modulator 875 modulate the data output from the first frame builder 860 and the second frame builder 865 such that the modulated data is transmitted in a state of being carried in the OFDM subcarriers, respectively.

The first transmitter 880 and the second transmitter 885 convert the digital signals output from the first modulator 870 and the second modulator 875 into analog signals and transmit the converted analog signals.

FIGs. 11 to 15 are views showing an example of a 2x2 code matrix for dispersing input symbols as an example of the encoding matrix of the linear pre-coder. The code matrixes of FIGs. 11 to 15 disperse two pieces of data input to the encoding unit of the linear pre-decoder 730 to two pieces of output data.

The matrix of FIG. 11 is an example of the vanderMonde matrix described with reference to FIG. 6, in which L is 2. In the matrix of FIG. 11, first input data and second input data, of which phase is rotated by 45 degrees ( $\frac{\pi}{4}$ ), of the two pieces of input data are added and first output data is output. Then, first input data and second input data, of which phase is rotated by 225 degrees ( $\frac{5\pi}{4}$ ), are added and second output data is output. The output data is divided by √2 so as to be scaled.

The code matrix of FIG. 12 is an example of the Hadamard matrix of FIG. 7.

In the matrix of FIG. 12, first input data and second input data of the two pieces of input data are added and first output data is output. Then, second input data are subtracted from first input data and second output data is output. The output data is divided by √2 so as to be scaled.

FIG. 13 shows another example of the code matrix for dispersing the input symbols. The matrix of FIG. 13 is an example of a code matrix different from the matrix described with reference to FIGs. 6, 7 and 8.

In the matrix of FIG. 13, first input data, of which phase is rotated by 45 degrees ( $\frac{\pi}{4}$ ), and second input data, of which phase is rotated by -45 degrees ( $-\frac{\pi}{4}$ ), of the two pieces of input data are added and first output data is output. Then, second input data, of which phase is rotated by -45 degrees, is subtracted from first input data, of which phase is rotated by 45 degrees, and second output data is output. The output data is divided by √2 so as to be scaled.

FIG. 14 shows another example of the code matrix for dispersing the input symbols. The matrix of FIG. 14 is an example of a code matrix different from the matrix described with reference to FIGs. 6, 7 and 8.

In the matrix of FIG. 14, first input data which is multiplied by 0.5 and second input data are added and first output data is output. Then, second input data which is multiplied by 0.5 is subtracted from first input data and second output data is output. The output data is divided by $\sqrt{1.25}$ so as to be scaled.

FIG. 15 shows another example of the code matrix for dispersing the input symbols. The matrix of FIG. 15 is an example of a code matrix different from the matrix described with reference to FIGs. 6, 7 and 8. "*" of FIG. 15 denotes a complex conjugate of the input data.

In the matrix of FIG. 15, first input data, of which phase is rotated by 90 degrees ( $\frac{\pi}{2}$ ), and second input data of the two pieces of input data are added and first output data is output. Then, the complex conjugate of first input data and the complex conjugate of second input data, of which phase is rotated by -90 degrees ( $-\frac{\pi}{2}$ ), are added, and second output data is output. The output data is divided by √2 so as to be scaled.

FIG. 16 is a view showing an example of an interleaving method of the interleaver. The interleaving method of FIG. 16 is an example of the interleaver of the OFDM system having a symbol length N, which can be used in the second interleaver 840 of the transmitting apparatus shown in FIG. 10.

N denotes the length of the interleaver and i has a value corresponding to the length of the interleaver, that is, an integer from 0 to N-1. n denotes the number of valid transmission carriers in a transmitting system. Π(i) denotes a permutation obtained by a modulo-N operation, and $d_n$ has a Π(i) value which is located in a valid transmission carrier area excluding a value N/2 in sequence. k denotes an index value of an actual transmission carrier. N/2 is subtracted from $d_n$ such that the center of the transmission bandwidth becomes DC. P denotes a permutation constant which may vary according to implementation embodiments.

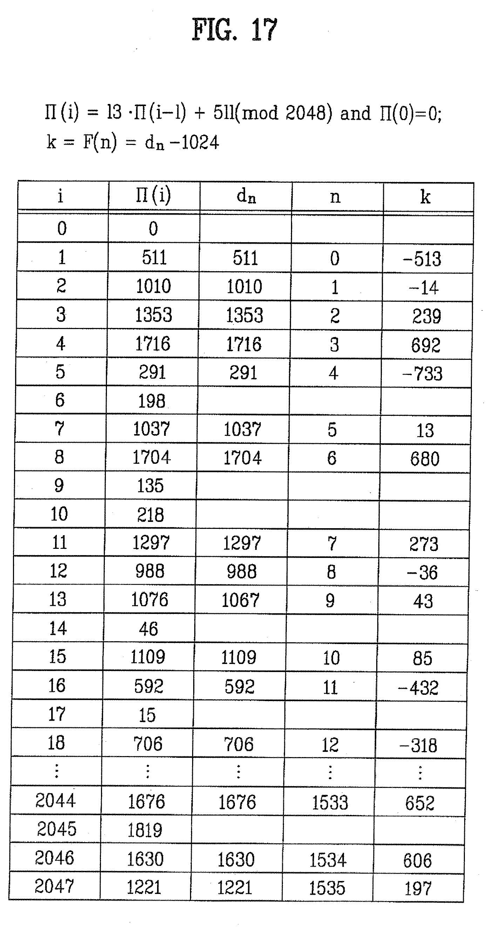

FIG. 17 is a view showing a variable which varies according to the interleaving method of FIG. 16. In the example of FIG. 17, the length of the OFDM symbol and the length N of the interleaver are set to 2048 and the number of valid transmission carriers are set to 1536 (1792-256).

Accordingly, i is an integer from 0 to 2047 and n is an integer from 0 to 1535. Π(i) denotes a permutation obtained by a modulo-2048 operation. $d_n$ has a Π(i) value with respect to a value 256≤Π(i)≤1792 excluding a value 1024 (N/2) in sequence. k denotes a value obtained by subtracting 1024 from $d_n$. P has a value of 13.

Using the interleaver according to the above-described method, data corresponding to the sequence i of the input data may be changed to the sequence k of the interleaved data with respect to the length N of the interleaver.

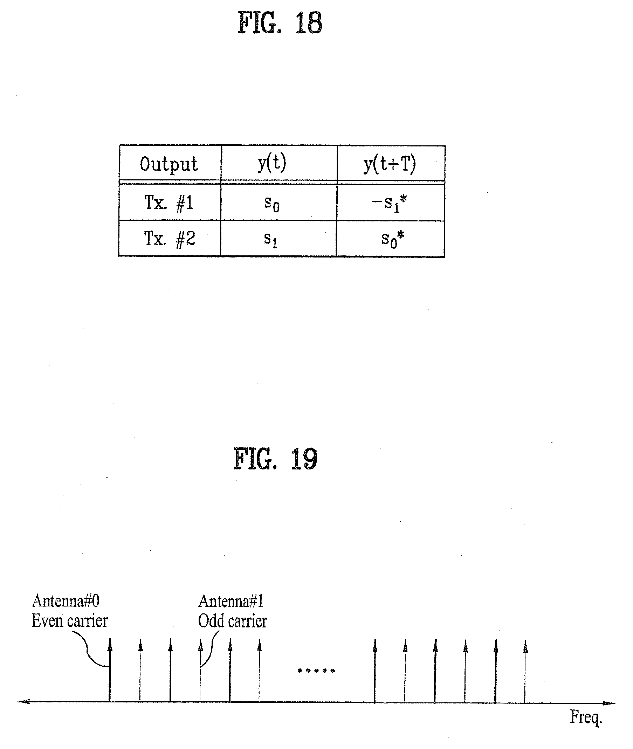

FIG. 18 is a view showing an example of the encoding method of the multi-input/output encoder. The embodiment of FIG. 18 is the STBC which is one of the multi-input/output encoding methods and may be used in the transmitting apparatus shown in FIG. 10.

In the example of the STBC encoder, T denotes a symbol transmission period, s denotes an input symbol to be transmitted, and y denotes an output symbol. * denotes a complex conjugate, and a first antenna (Tx #1) and a second antenna (Tx #2) denote a first transmission antenna and a second transmission antenna 2, respectively.

In the example of FIG. 18, at a time t, the first antenna Tx #1 transmits s0 and the second antenna Tx #2 transmits s1. At a time t+T, the first antenna Tx #1 transmits -s1* and the second antenna Tx #2 transmits s0*. The transmission antennas transmit data having the same information of s0 and s1 in the transmission period. Accordingly, the receiver can obtain spatial diversity effect using the signals output from the multi-input/output encoder according to the method shown in FIG. 18.

The signals transmitted by the first antenna and the second antenna shown in FIG. 18 are examples of the multi-input/output encoded signals. When FIG. 18 is described from a different viewpoint, the signals transmitted by the first antenna and the second antenna may be transmitted by a multi-input single-output method.

In the example of FIG. 18, it may be considered that two temporally consecutive signals s0 and -s1* are input to a path of the first antenna and signals s1 and s0* are input to a path of the second antenna. Accordingly, since the signals s0 and -s1* are consecutively output to the first antenna and the signals s1 and s0* are output to the second antenna, it may be considered that the output symbols are transmitted by the multi-input single-output method. FIG. 18 shows a simplest example using two antennas. The signals may be transmitted according to the method shown in FIG. 18 using more antennas.

That is, when the example of FIG. 18 is described by the multi-input single-output method, the consecutive first and second symbols are multi-input and a minus of a complex conjugate of the second symbol and a complex conjugate of the first symbol are simultaneously output. The multi-input symbols may be encoded according to an Alamouti algorithm and the encoded symbols may be output.

The multi-input/output encoder may transmit the signals which are interleaved by the second interleaver in the frequency domain, by the multi-input single-output method. The multi-input/output (including the multi-input single-output) shown in FIG. 17 is not applied to the pilot symbol interval shown in FIGs. 18 and 19 and is applied to only the data symbol interval.

FIG. 19 is a view showing a structure of the pilot carriers in the pilot symbol intervals built by the first and second frame builders of FIG. 10. The pilot symbol intervals built by the frame builders of FIG. 10 may be output as shown in FIG. 9.

The pilot carriers included in the frames output from the first and second frame builders are output to the first and second antennas, respectively. Accordingly, FIG. 19 shows the respective pilot symbols built by the first and second frame builders as the signals output from the first and second antennas.

In the respective pilot symbol intervals output from the first and second frame builders of FIG. 10, an even-numbered pilot carrier and an odd-numbered pilot carrier are respectively interleaved as shown in FIG. 19 and the interleaved carriers may be output to the first and second antennas #1 and #2.

For example, only the even-numbered pilot carrier information of the generated pilot carriers is included in the pilot symbol interval built by the first frame builder and is transmitted via the first antenna #1. Only the odd-numbered pilot carrier information of the generated pilot carriers is included in the pilot symbol interval built by the second frame builder and is transmitted via the second antenna. Accordingly, the receiver can distinguish between the transmission paths using the carrier indexes of the pilot symbol intervals received via the two signal paths. The structure of the pilot symbol interval of FIG. 19 may be used when the multi-input/output encoding is performed so as to have the two transmission paths as shown in FIG. 12.

In the embodiment of FIG. 19, a channel corresponding to a subcarrier of a half of a frame may be estimated from a symbol. Accordingly, high channel estimation performance can be obtained with respect to a transmission channel having a short coherence time.

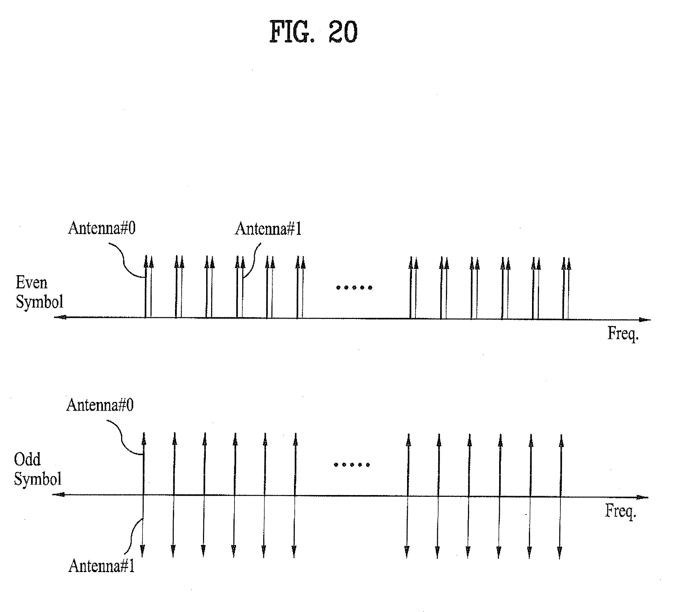

FIG. 20 is a view showing another structure of the pilot carriers in the pilot symbol intervals built by the first and second frame builders of FIG. 10. Even in the example of FIG. 20, different pilot carriers are transmitted to the pilot symbol intervals with respect to the paths according to the multi-input/output encoding method.

It can be explained along with the pilot symbol intervals including even-numbered intervals and odd-numbered intervals. In even-numbered intervals, antenna #0 and #1 transmit the same pilot carriers, respectively and in odd-numbered intervals, antenna #0 and #1 transmit the pilot carriers of which phases are opposite each other. The receiver can use sum and difference of the pilot carriers respectively transmitted through two paths.

The pilot symbol interval includes even-numbered intervals and odd-numbered intervals which are arranged with time. A pilot carrier according to a sum of pilot carrier information which will be transmitted via a first path (first antenna (denoted by antenna #0)) and pilot carrier information which will be transmitted via a second path (second antenna (denoted by antenna #1)) is transmitted to the even-numbered interval. A pilot carrier according to a difference between pilot carrier information which will be transmitted via the first path (first antenna (denoted by antenna #0)) and pilot carrier information which will be transmitted via the second path (second antenna (denoted by antenna #1)) is transmitted to the odd-numbered interval. The receiver can recognize the sum of or difference between the two pieces of pilot carrier information via a received pilot index and distinguish between the transmission paths.

In this embodiment, a channel corresponding to all subcarriers can be estimated and the estimation length of delay spread of the channel which can be processed by each transmission path can be extended by a symbol length.

The example of FIG. 20 is shown for facilitating the distinguishment between the two pieces of pilot carrier information and shows both the two pieces of pilot carrier information in the frequency domain. In the even-numbered symbol interval and the odd-numbered symbol interval, impulses of the two pieces of pilot carrier information are located at the same frequency point.

The embodiments of FIGs. 19 and 20 are examples of having two transmission paths. If the number of transmission paths is larger than 2, the pilot carrier information may be divided so as to be distinguished by the number of transmission paths similar to FIG. 19 or may be subjected to Hadamard conversion in the unit of a symbol interval and the converted information may be transmitted similar to FIG. 20.

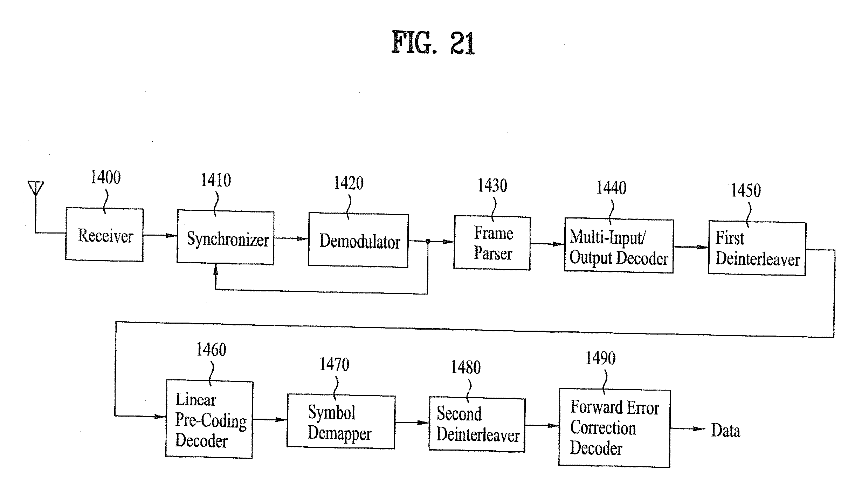

FIG. 21 is a block diagram showing an apparatus for receiving a signal according to another embodiment of the present invention. The apparatus for transmitting/receiving the signal may be a system for transmitting/receiving a broadcasting signal according to a DVB system.

The embodiment of FIG. 21 includes a receiver 1400, a synchronizer 1410, a demodulator 1420, a frame parser 1430, a multi-input/output decoder 1440, a first deinterleaver 1450, a linear pre-coding decoder 1460, a symbol demapper (trellis coded modulation decoder) 1470, a second deinterleaver 1480, and a forward error correction (FEC) decoder 1490. The embodiment of FIG. 21 will be described concentrating on a process of processing the signal by the signal receiving system.

The receiver 1400 down-converts the frequency band of a received RF signal, converts the signal into a digital signal, and outputs the digital signal. The synchronizer 1410 acquires synchronization of the received signal output from the receiver 1400 in a frequency domain and a time domain and outputs the synchronization. The synchronizer 1410 may use an offset result of the data output from the demodulator 1420 in the frequency domain, for acquiring the synchronization of the signal in the frequency domain.

The demodulator 1420 demodulates the received data output from the synchronizer 1410 and removes the guard interval. The demodulator 1420 may convert the reception data into the frequency domain and obtain data values dispersed into the subcarriers.

The frame parser 1430 may output symbol data of the data symbol interval excluding the pilot symbol according the frame structure of the signal demodulated by the demodulator 1420. The frame parser 1430 may parse the frame using at least one of a scatter pilot carrier of which position is temporally shifted in the data carrier interval and a continuation pilot carrier of which position is temporally fixed in the data carrier interval.

The multi-input/output decoder 1440 receives the data output from the frame parser 1430, decodes the data, and outputs a data stream. The multi-input/output decoder 1440 decodes the data stream received via the plurality of transmission antennas according to a method corresponding to the transmitting method of the multi-input/output encoder shown in FIG. 1 and outputs a data stream.

The first deinterleaver 1450 deinterleaves the data stream output from the multi-input/output decoder 1440 and restores the data into the sequence of the data before interleaving. The first deinterleaver 1450 deinterleaves the data stream according to a method corresponding to the interleaving method of the second interleaver shown in FIG. 1 and restores the sequence of the data stream.

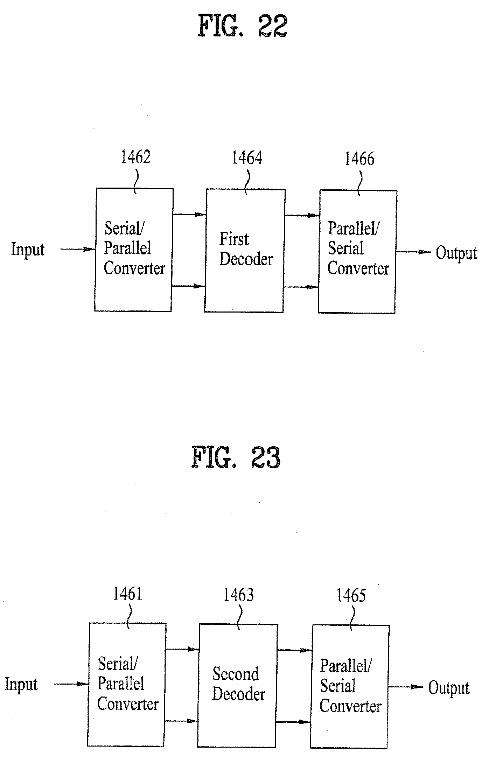

The linear pre-coding decoder 1460 performs an inverse process of the process of dispersing the data in the apparatus for transmitting the signal. Accordingly, the data dispersed according to the linear pre-coding may be restored to the data before dispersing. The embodiment of the linear pre-coding decoder 1460 is shown in FIGs. 22 to 23.

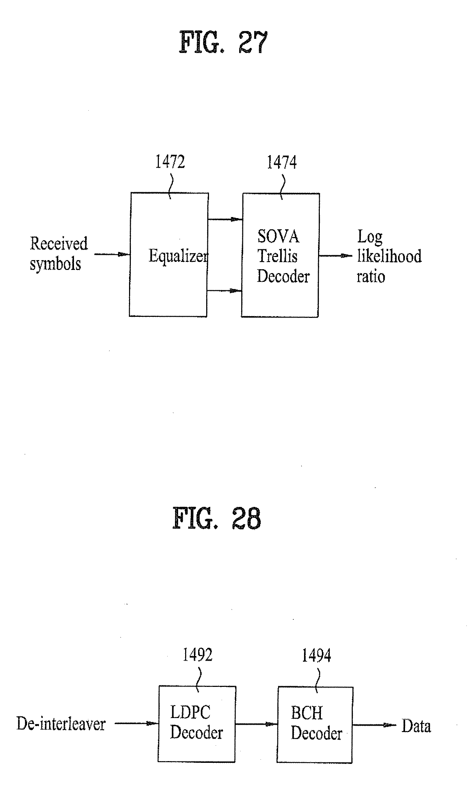

The symbol demapper 1470 may restore the coded symbol data output from the linear pre-coding decoder 1460 into a bit stream. The symbol demapper 1470 is also called trellis coded modulation decoder, hereinafter when the symbol is demapped according to trellis coded modulation decoding.The example of the trellis coded modulation decoder 1470 is shown in FIG. 27.

The second deinterleaver 1480 deinterleaves the data stream output from the trellis coded modulation decoder 1470 and restores the data into the sequence of the data before interleaving. The second deinterleaver 1480 deinterleaves the data according to a method corresponding to the interleaving method of the first interleaver shown in FIG. 1 and restores the sequence of the data stream.

The FEC decoder 1490 FEC-decodes the data, in which the sequence of the data stream is restored, detects an error which occurs in the received data, and corrects the error. The example of the FEC decoder 1490 is shown in FIG. 28.

FIG. 22 is a schematic block diagram showing an example of the linear pre-coding decoder of FIG. 11. The linear pre-coding decoder 1460 includes a serial/parallel converter 1462, a first decoder 1464 and a parallel/serial converter 1466.

The serial/parallel converter 1462 converts the input data into parallel data. The first decoder 1464 may restore the data, which is linearly pre-coded and is dispersed into the parallel data, as original data via a decoding matrix. The decoding matrix for performing decoding becomes an inverse matrix of the encoding matrix of the apparatus for transmitting the signal. For example, when the apparatus for transmitting the signal performs the encoding operation using the vanderMonde matrix, the Hadamard matrix and the Golden code shown in FIGs. 6, 7 and 8, the first decoder 1464 restores the dispersed data as the original data using the inverse matrixes of the matrixes.

The parallel/serial converter 1466 converts the parallel data received by the first decoder 1464 into the serial data and outputs the serial data.

FIG. 23 is a schematic block diagram showing another example of the linear pre-coding decoder. The linear pre-coding decoder 1460 includes a serial/parallel converter 1461, a second decoder 1463 and a parallel/serial converter 1465.

The serial/parallel converter 1461 converts the input data into parallel data, the parallel/serial converter 1465 converts the parallel data received from the second decoder 1463 into serial data and outputs the serial data. The second decoder 1463 may restore the original data, which is linearly pre-coded and is dispersed into the parallel data output from the serial/parallel converter 1461, using maximum likelihood (ML) decoding.

The second decoder 1463 is the ML decoder for decoding the data according to the transmitting method of the transmitter. The second decoder 1463 ML-decodes the received symbol data according to the transmitting method and restores the data dispersed in the parallel data to the original data. That is, the ML decoder ML-decodes the received symbol data according to the encoding method of the transmitter.

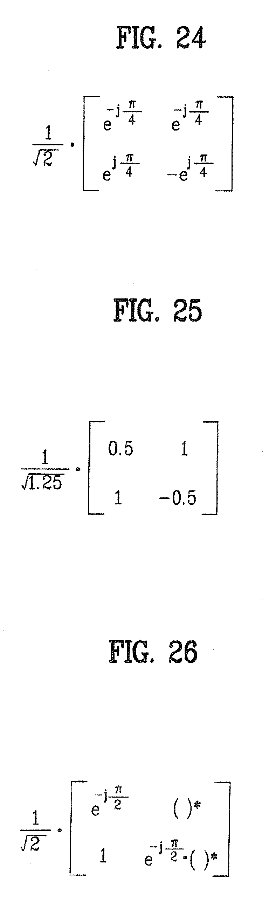

FIGs. 24 to 26 are views showing examples of a 2×2 code matrix for restoring the dispersed symbols. The code matrixes of FIGs. 24 to 26 show inverse matrixes corresponding to the 2×2 encoding matrixes of FIGs. 13 to 15. According to FIGs. 24 to 26, the code matrixes restore data which is dispersed into two pieces of data input to the decoding unit of the linear pre-coding decoder 1460 and output the restored data.

In more detail, the 2×2 code matrix of FIG. 24 is a decoding matrix corresponding to the encoding matrix of FIG. 13.

In the matrix of FIG. 24, first input data, of which phase is rotated by -45 degrees $(-\frac{\pi}{4})$, and second input data, of which phase is rotated by -45 degrees $(-\frac{\pi}{4})$, of the two pieces of input data are added and first output data is output. Then, second input data, of which phase is rotated by -45 degrees, is subtracted from first input data, of which phase is rotated by 45 degrees, and second output data is output. The output data is divided by $\sqrt{2}$ so as to be scaled.

FIG. 25 shows another example of the 2×2 code matrix. The matrix of FIG. 25 is a decoding matrix corresponding to the encoding matrix of FIG. 14. In the matrix of FIG. 14, first input data which is multiplied by 0.5 and second input data are added and first output data is output. Then, second input data which is multiplied by 0.5 is subtracted from first input data and second output data is output. The output data is divided by $\sqrt{1.25}$ so as to be scaled.

FIG. 26 shows another example of the 2×2 code matrix. The matrix of FIG. 26 is a decoding matrix corresponding to the encoding matrix of FIG. 15. "*" of FIG. 26 denotes a complex conjugate of the input data.

In the matrix of FIG. 26, first input data, of which phase is rotated by -90 degrees $(-\frac{\pi}{2})$, and the complex conjugate of second input data are added and first output data is output. Then, the first input data and the complex conjugate of second input data, of which phase is rotated by -90 degrees $(-\frac{\pi}{2})$, are added, and second output data is output. The output data is divided by $\sqrt{2}$ so as to be scaled.

FIG. 27 is a schematic block diagram showing an example of the trellis coded modulation decoder. The trellis coded modulation decoder 1470 includes an equalizer 1472 and soft-output viterbi algorithm (SOVA) trellis decoder 1474.

Since the trellis coded modulation coding is performed at a symbol level, a channel distortion can be compensated for with respect to the received symbol data. The equalizer 1472 compensates for a distortion of the transmission channel and outputs symbol data. The position of the equalizer at the symbol level is not limited to the example of FIG. 27. For example, as shown in FIG. 21, the linear pre-coding decoder 1460 may perform equalization with respect to the pre-coding decoded symbol data or the equalizer may be located at the output position of the first deinterleaver 1450, the output position of the multi-input/output decoder 1440 and the output position of the frame parser 1430. That is, the position of the equalizer 1472 may vary according to the implementation embodiments.

In the example of FIG. 27, the equalized symbol data is input to the SOVA trellis decoder 1474. The SOVA trellis decoder 1474 trellis-decodes the received symbol data, de-maps the transmitted symbol data to bit data, and decodes the data. If the LDPC code is used as the FEC code, for ensuring LDPC decoding performance, the SOVA trellis decoder 1474 outputs a log likelihood ratio (LLR) of the output bits.

For trellis decoding, as shown in FIG. 27, the SOVA trellis decoder may be used or a hard decision type trellis decoder may be used in consideration of complexity.

FIG. 28 is a schematic block diagram showing the FEC decoder. The FEC decoder 1490 corresponds to the FEC encoder of FIG. 1. As an inner decoder and an outer decoder, a LDPC decoder 1492 and a BCH decoder 1494 are included, respectively.

The LDPC decoder 1492 detects a transmission error which occurs in a channel and corrects the error, and the BCH decoder 1494 corrects the remaining error of the data decoded by the LDPC decoder 1492 and removes an error floor.

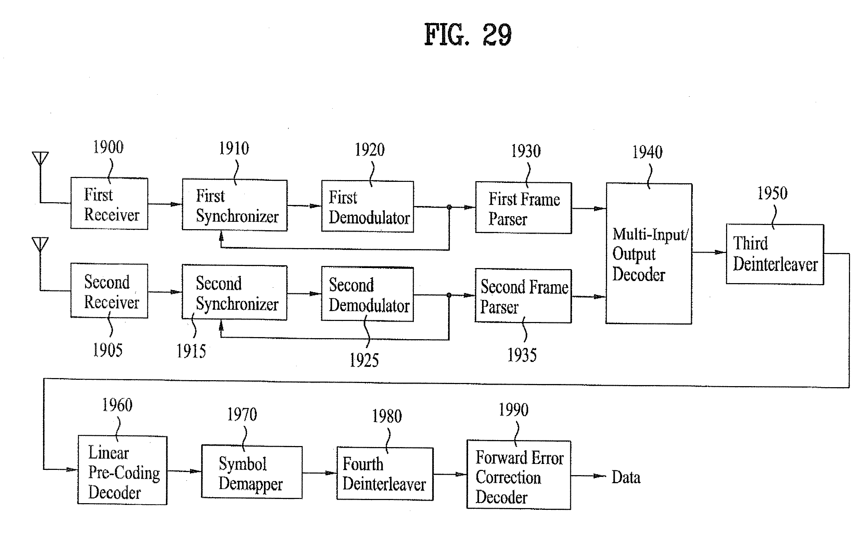

FIG. 29 is a block diagram showing an example of a signal receiving apparatus which processes a signal via a plurality of reception paths as an embodiment of the signal receiving apparatus. Hereinafter, for convenience of description, a case that the number of reception paths is two will be described.

The embodiment of FIG. 29 includes a first receiver 1900, a second receiver 1905, a first synchronizer 1910, a second synchronizer 1915, a first demodulator 1920, a second demodulator 1925, a first frame parser 1930, a second frame parser 1935, a multi-input/output decoder 1940, a third deinterleaver 1950, a linear pre-coding decoder 1960, a trellis coded modulation decoder 1970, a fourth deinterleaver 1980 and a FEC decoder 1990.

The first receiver 1900 and the second receiver 1905 receive RF signals, down-convert frequency bands, convert the signals into digital signals, and output the digital signals, respectively. The first synchronizer 1910 and the second synchronizer 1915 acquire synchronizations of the received signals output from the first receiver 1900 and the second receiver 1905 in the frequency domain and the time domain and output the synchronizations, respectively. The first synchronizer 1910 and the second synchronizer 1915 may use offset results of the data output from the first demodulator 1920 and the second demodulator 1925 in the frequency domain, for acquiring the synchronizations of the signal in the frequency domain, respectively.

The first demodulator 1920 demodulates the received data output from the first synchronizer 1910. The first demodulator 1920 converts the received data into the frequency domain and decodes the data dispersed in the subcarriers to the data allocated to the subcarriers. The second demodulator 1925 demodulates the received data output from the second synchronizer 1915.

The first frame parser 1930 and the second frame parser 1935 distinguish between the reception paths according to the frame structures of the signals demodulated by the first demodulator 1920 and the second demodulator 1925 and output symbol data of the data symbol interval excluding the pilot symbol, respectively.

The multi-input/output decoder 1940 receives the data output from the first frame parser 1930 and the second frame parser 1935, decodes the data, and outputs a data stream.

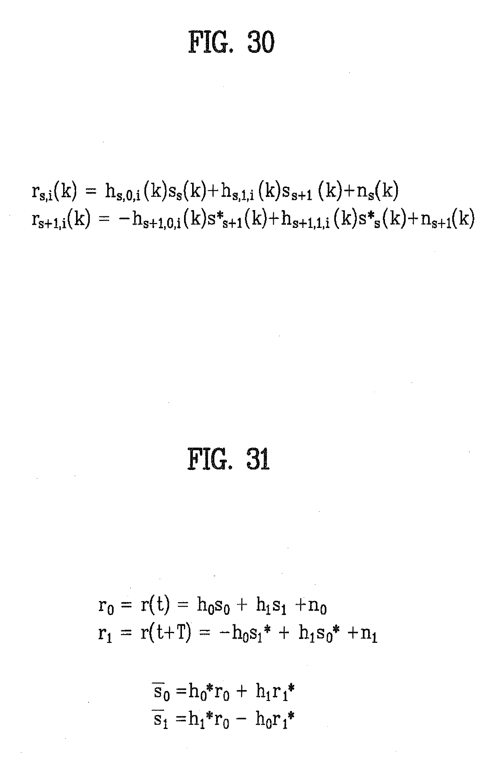

FIG. 30 is a view showing an example of a decoding method of the multi-input/output decoder. That is, FIG. 30 shows a decoding example of the receiver when the transmitter multi-input/output encodes data by the STBC method and transmits the encoded data. The transmitter may use two transmission antennas. This is only exemplary and another multi-input/output method may be applied.

In the equation, r(k), h(k), s(k) and n(k) represent a symbol received by the receiver, a channel response, a symbol value transmitted by the transmitter, and channel noise, respectively. Subscripts s, i, 0 and 1 represent a $s^{th}$ transmission symbol, an $i^{th}$ reception antenna, $0^{th}$ transmission antenna and $1^{st}$ transmission antenna, respectively. "*" represents a complex conjugate. For example, $h_{s,1,i}(k)$ represents a response of a channel experienced by the transmitted symbol when a $s^{th}$ symbol transmitted via the first transmission antenna is received by the $i^{th}$ reception antenna. $R_{s+1,i}(k)$ represents a $s+1^{th}$ reception symbol received by the $i^{th}$ reception antenna.

According to the equation of FIG. 30, $R_{s,i}(k)$ which is a $s^{th}$ reception symbol received by the $i^{th}$ reception antenna becomes a value obtained by adding the $s^{th}$ symbol value transmitted from the $0^{th}$ transmission antenna to the $i^{th}$ reception antenna via the channel, the $s^{th}$ symbol value transmitted from the $1^{st}$ transmission antenna to the $i^{th}$ reception antenna via the channel and a sum $n_s(k)$ of the channel noises of the channels.

$R_{s+1,i}(k)$ which is the $s+1^{th}$ reception symbol received by the $i^{th}$ reception antenna becomes a value obtained by adding the $s+1^{th}$ symbol value $-h_{s+1,0,i}$ transmitted from the $0^{th}$ transmission antenna to the $i^{th}$ reception antenna via the channel, the $s+1^{th}$ symbol value $h_{s+1,1,i}$ transmitted from the $1^{st}$ transmission antenna to the $i^{th}$ reception antenna via the channel and a sum $n_{s+1}(k)$ of the channel noises of the channels.

FIG. 31 is a view showing a detailed example of the reception symbol FIG. 30. FIG. 31 shows a decoding example when the transmitter multi-input/output encodes data by the STBC method and transmits the encoded data, that is, shows an equation which can obtain the received symbol when the data is transmitted using two transmission antennas and the data transmitted via the two transmission data is received using one antenna.

The transmitter transmits a signal using two transmission antennas and the receiver receives the signal using one transmission antenna, the number of transmission channels may be two. In the equation, $h_0$ and $s_0$ respectively represent a transmission channel response from the $0^{th}$ transmission antenna to the reception antenna and a symbol transmitted from the $0^{th}$ transmission antenna, and $h_1$ and $s_1$ respectively represent a transmission channel response from the $1^{st}$ transmission antenna to the reception antenna and a symbol transmitted from the $1^{th}$ transmission antenna. "*" represents a complex conjugate and $s_0'$ and $s_1'$ of the following equation represent restored symbols.

In addition, $r_0$ and $r_1$ respectively represent a symbol by the reception antenna at a time t and a symbol received by the reception antenna at a time t+T after a transmission period T is elapsed, and no and $n_1$ represent values of sums of channel noises of the transmission paths at reception times.

As expressed by the equation of FIG. 31, the signals $r_0$ and $r_1$ received by the reception antenna may be represented by values obtained by adding the signals transmitted by the transmission antennas and values distorted by the transmission channels. The restored symbols $s_0$' and $s_1$' are calculated using the received signals $r_0$ and $r_1$ and the channel response values $h_0$ and $h_1$.

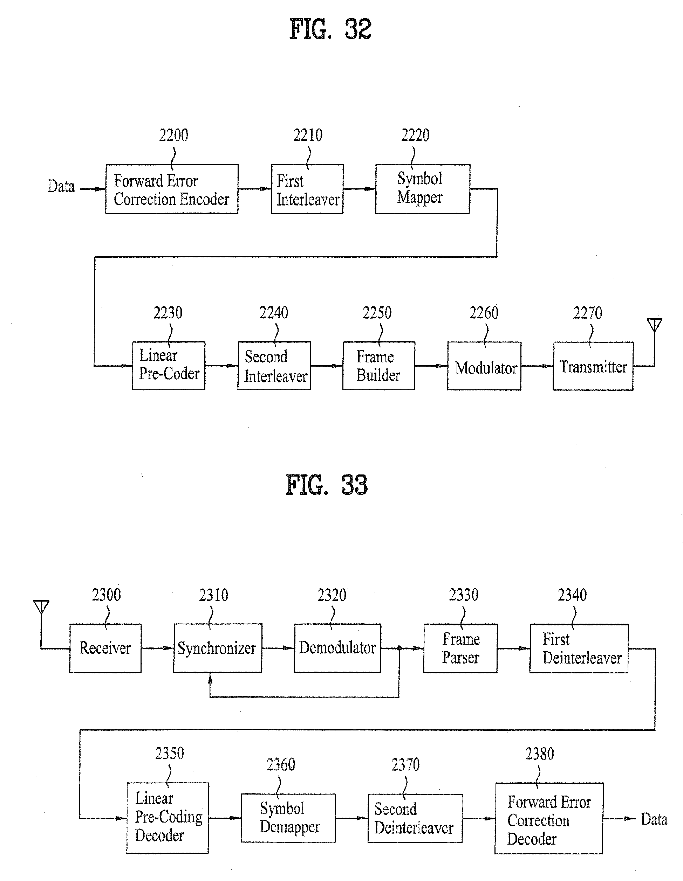

FIG. 32 is a schematic block diagram showing another example of the apparatus for transmitting the signal. FIG. 32 is a schematic block diagram showing another example of the apparatus for receiving the signal.

FIGs. 32 and 33 show examples of applying a single-input single-output (SISO) method to the system instead of the multi-input/output method.

The signal transmitting apparatus of FIG. 32 includes a FEC error correction encoder 2200, a first interleaver 2210, a trellis coded modulator 2220, a linear pre-coder 2230, a second interleaver 2240, a frame builder 2250, a modulator 2260 and a transmitter 2270.

The signal receiving apparatus of FIG. 33 includes a receiver 2300, a synchronizer 2310, a demodulator 2320, a frame parser 2330, a first deinterleaver 2340, a linear pre-coding decoder 2350, a trellis coded modulation decoder 2360, a second deinterleaver 2370 and a FEC decoder 2380.

The signal transmitting apparatus and the signal receiving apparatus perform the same process as the respective above-described apparatuses. However, since the transmitting apparatus and the receiving apparatus shown in FIGs. 32 and 33 use the SISO method instead of the multi-input/output method, the multi-input/output encoding process and the multi-input/output decoding process are not used.

That is, the symbol data which is subjected to the linear pre-coding operation and the interleaving operation so as to become robust against the frequency selective facing of the channel is input to the frame builder 2250. The frame builder 2250 builds the frame data having the structure shown in FIG. 9 on the basis of the input symbol data and outputs the built frame data. In the SISO method, it is unnecessary to distinguish between the transmission paths according to the multi-input/output shown in FIGs. 19 and 20.

In the signal receiving apparatus, the symbol data parsed by the frame parser 2330 is output to the first deinterleaver 2340 such that the inverse process of the data processing of the transmitting apparatus so as to become robust against the frequency selective fading of the channel is performed.

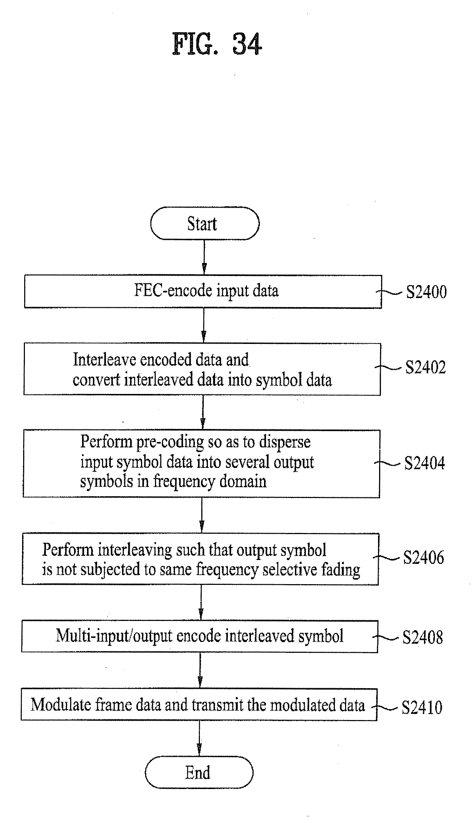

FIG. 34 is a flowchart illustrating a method of transmitting a signal according to the present invention.

FEC encoding is performed with respect to input data such that a transmission error of transmission data is found and corrected (S2400). BCH encoder may be used as an outer encoder for preventing an error floor and a LDPC encoding method may be performed after a BCH encoding method is performed, for FEC encoding.

The encoded data is interleaved so as to become robust against a burst error of a transmission channel and the interleaved data is converted into symbol data according to the transmitting/receiving system (S2402). For conversion into the encoded symbol data, a trellis coded modulation encoder may be used. As the symbol form, QAM or QPSK may be used.

In order to allow the symbol data to be robust against the frequency selective fading of the channel, the mapped symbol data is pre-coded so as to be dispersed into several output symbols in the frequency domain (S2404) and the pre-coded symbol data is interleaved (S2406). Accordingly, it is possible to reduce a probability that the data is lost in the frequency selective fading channel. In the interleaving, a convolution interleaver or a block interleaver may be used, which may be selected according to implementation embodiments.

Accordingly, it is possible to reduce a probability that all information is lost by fading when the frequency selective fading channel is experienced and disallow the dispersed symbol data to be subjected to the same frequency selective fading. In the interleaving, a convolution interleaver or a block interleaver may be used, which may be selected according to implementation embodiments.

The interleaved symbol data is multi-input/output encoded so as to be transmitted via a plurality of antennas (S2408). The number of data transmission paths may be decided according to the number of antennas. In the spatial diversity method, data having the same information is transmitted via the paths and, in the spatial multiplexing method, different data is transmitted via the paths.

The encoded data is converted into the transfer frame according to the number of multi-input/output transmission paths, the transfer frame is modulated, and the modulated transfer frame is transmitted (S2410). The transfer frame includes a pilot carrier symbol interval and a data symbol interval. The pilot carrier symbol interval may have information which can distinguish between the transmission paths. For example, when the signal is transmitted via two antennas, even-numbered carriers and odd-numbered carriers of the generated pilot carriers may be transmitted via different antennas. Alternatively, when the signal is transmitted via two antennas, a sum of pilot carriers is transmitted at an even-numbered symbol position and a difference between pilot carriers is transmitted at an odd-numbered symbol positions such that the diversity effect can be obtained.

However, in the signal transmitting/receiving system using the SISO method instead of the multi-input/output method, the modulated signal is transmitted via one antenna without performing the multi-input/output encoding step S2408.

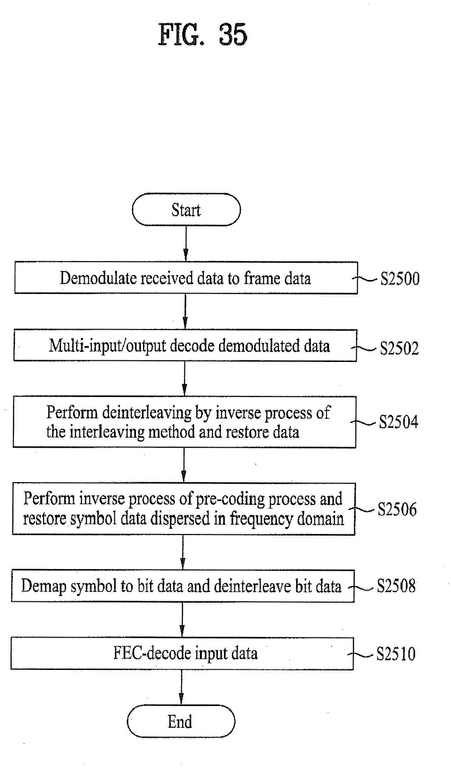

FIG. 35 is a flowchart illustrating a method of receiving a signal.

A signal received via a transmission path is synchronized and the synchronized signal is demodulated (S2500).

The demodulated data frame is parsed and the multi-input signal is decoded according to a multi-input/output decoding method so as to obtain a symbol data stream (S2502).

The symbol data which is interleaved to become robust against the frequency selective fading of the channel is deinterleaved by the inverse process of the interleaving process (S2504). The data stream which is restored by the deinterleaving is decoded by the inverse process of the pre-coding process and original symbol data which is dispersed into several pieces of symbol data is restored in the frequency domain (S2506).

The restored symbol data is demapped according to a symbol mapping method and is decoded to bit data, and the bit data is deinterleaved so as to be restored in original sequence (S2508). As the method of demapping and decoding the encoded symbol data, a trellis coded modulator decoding method may be used. Equalization may be performed at a symbol level and an equalization process may vary according to the implementation embodiments.

The FEC decoding is performed with respect to the restored data such that a transmission error is corrected (S2510). For FEC decoding, a LDPC decoder may be used and, as an outer decoder for preventing an error floor, a BCH decoding method may be performed after the LDPC decoding method is performed.

However, in the signal transmitting/receiving system using the SISO method instead of the multi-input/output method, the signal received via one transmission path is performed without performing the multi-input/output decoding step S2502.

A method of transmitting/receiving a signal and an apparatus for transmitting/receiving a signal according to the present invention is available in broadcasting and communication fields.

According to a method of transmitting/receiving a signal and an apparatus for transmitting/receiving a signal of the present invention, it is possible to facilitate the switching of a signal transmitting/receiving system using the existing signal transmitting/receiving network and reduce cost.

In addition, it is possible to improve a data transfer rate such that a SNR gain can be obtained and estimate a channel with respect to a transmission channel having a long delay spread property so as to increase a signal transmission distance by. Accordingly, it is possible to improve the signal transmission/reception performance of the transmitting/receiving system.

**Claims**

1. An apparatus for transmitting a signal, the apparatus comprising:

   a forward error correction (FEC) encoder (100) performing forward error correction (FEC) encoding with respect to input data according to a Bose-chaudhuri-Hocquenghem (BCH) coding scheme and a low density parity check (LDPC) coding scheme;
   a first interleaver (110) interleaving the FEC-encoded data;
   a symbol mapper (120) converting the interleaved data into data symbols;
   a second interleaver (140) interleaving the data symbols;
   an encoder (150) encoding the data symbols interleaved by the second interleaver;
   a pilot symbol inserter (160) inserting at least one pilot symbol into a data frame including the encoded data symbols; and
   a transmitter (180) transmitting the data frame including the pilot symbols and the data symbols.

2. The apparatus according to claim 1, wherein the pilot symbol inserter (160) inserts the at least one pilot symbol in a beginning portion in the data frame.

3. The apparatus according to claim 1, wherein the second interleaver (140) stores the converted data symbols column-wise in a memory and reads the stored data symbols row-wise.

4. The apparatus according to claim 1, wherein the encoder (150) receives consecutive first and second symbols and encodes the symbols such that

$$Y\_tx1\ (t)\ =\ S0, \qquad Y\_tx1\ (t+T)\ =\ S1,$$

$$Y\_tx2\ (t)\ =\ -S1*, \qquad Y\_tx2\ (t+T)\ =\ S0*,$$

where S0 represents the first symbol, S1 represents the second symbol, * represents a complex conjugate, Y_tx1 represents the encoded symbols to be transmitted through a first antenna, Y_tx2 represents the encoded symbols to be transmitted through a second antenna, t represents a time at which the symbols are transmitted, and T represents a time period between which the first symbol and the second symbol are transmitted respectively.

5. The apparatus according to claim 1, wherein the encoder (150) receives consecutive first and second symbols and encodes the symbols such that a minus of a complex conjugate of the second symbol and a complex conjugate of the first symbol are output simultaneously with the first and second symbols.

6. An apparatus for receiving a signal, the apparatus comprising:

a receiver (1300) receiving a data frame including data symbols and at least one pilot symbol;
a frame parser (1330) parsing the data symbols from the received data frame;
a decoder (1340) decoding the parsed data symbols;
a first deinterleaver (1350) deinterleaving the decoded data symbols;
a symbol demapper (1370) converting the deinterleaved data symbols into bit data;
a second deinterleaver (1380) deinterleaving the converted bit data; and
a forward error correction (FEC) decoder (1390) performing forward error correction (FEC) decoding with respect to the deinterleaved bit data according to a Bose-chaudhuri-Hocquenghem (BCH) decoding scheme and a low density parity check (LDPC) decoding scheme.

7. The apparatus according to claim 6, wherein the at least one pilot symbol is included in a beginning portion of the data frame.

8. The apparatus according to claim 6, wherein the decoder (1340) decodes the parsed data symbols according to an Alamouti algorithm.

9. The apparatus according to claim 6, wherein the first deinterleaver (1350) stores the decoded data symbols column-wise in a memory and reads the stored data symbols row-wise.

10. A method of transmitting a signal, the method comprising:

performing forward error correction (FEC) encoding with respect to input data according to a Bose-chaudhuri-Hocquenghem (BCH) coding scheme and a low density parity check (LDPC) coding scheme;
interleaving the FEC-encoded data;
converting the interleaved data into data symbols;
interleaving the data symbols;
encoding the interleaved data symbols;
inserting at least one pilot symbol into a data frame including the encoded data symbols; and
transmitting the data frame including the pilot symbols and the data symbols.

11. The method according to claim 10, the converted data symbols are interleaved in a manner that the converted data symbols are stored column-wise in a memory and the stored data symbols are read out row-wise.

12. The method according to claim 10, wherein in the encoding of the interleaved data symbols, first and second symbols in the interleaved data symbols are encoded such that Y_tx1 (t) = S0, Y_tx1 (t+T) = S1,

$$Y\_tx2\ (t)\ =\ -S1*, \qquad Y\_tx2\ (t+T)\ =\ S0*,$$

where S0 represents the first symbol, S1 represents the second symbol, * represents a complex conjugate, Y_tx1 represents the encoded symbols to be transmitted through a first antenna, Y_tx2 represents the encoded symbols to be transmitted through a second antenna, t represents a time at which the symbols are transmitted, and T represents a time period between which the first symbol and the second symbol are transmitted respectively.

13. A method of receiving a signal, the method comprising:

receiving a data frame including data symbols and at least one pilot symbol;
parsing the data symbols from the received data frame;
decoding the parsed data symbols;
deinterleaving the decoded data symbols;
converting the deinterleaved data symbols into bit data;
deinterleaving the converted bit data; and
performing forward error correction (FEC) decoding with respect to the deinterleaved bit data according to a Bose-chaudhuri-Hocquenghem (BCH) decoding scheme and a low density parity check (LDPC) decoding scheme.

14. The method according to claim 13, wherein the parsed data symbols are decoded according to an Alamouti algorithm.

15. The method according to claim 13, wherein the decoded data symbols are interleaved in an manner that the decoded data symbols are stored column-wise in a memory and the stored data symbols are read out row-wise.

FIG. 1

# FIG. 2

102        104

Data → | BCH Encoder | → | LDPC Encoder | → Interleaver

# FIG. 3

Number of column, NC

Number of row, Nr

MSB

LSB

------ WRITE        — · — READ

## FIG. 4

Xn ——————————————————————————→ Yn

⋮

X2 ——————————————————————————→ Y2

X1 —————————————————●————————→ Y1

$$\boxed{D}\ \underset{122}{} \quad \oplus\ \underset{126}{} \quad \boxed{D}\ \underset{124}{} ———→ Y0$$

## FIG. 5

Input ——→ | Serial/ Parallel Converter | 132 ——→ | Encoder | 134 ——→ | Parallel/ Serial Converter | 136 ——→ Output

## FIG. 6

$$\Theta = \frac{1}{\sqrt{L}} \begin{bmatrix} 1 & \theta_1 & \theta_1^2 & \cdots & \theta_L^{L-1} \\ 1 & \theta_2 & \theta_2^2 & \cdots & \theta_L^{L-1} \\ \cdots & \cdots & \cdots & \cdots & \cdots \\ 1 & \theta_L & \theta_L^2 & \cdots & \theta_L^{L-1} \end{bmatrix}$$

$$\theta_k = \exp\left( j\frac{\pi(4k-3)}{2L} \right)$$

## FIG. 7

$$H_{2k} = \frac{1}{\sqrt{2^k}} \cdot \begin{bmatrix} H_{2k-1} & H_{2k-1} \\ H_{2k-1} & -H_{2k-1} \end{bmatrix}, \quad H_2 = \frac{1}{\sqrt{2}} \cdot \begin{bmatrix} 1 & 1 \\ 1 & -1 \end{bmatrix}$$

# FIG. 8

$$C = \frac{1}{\sqrt{5}} \begin{bmatrix} \alpha(x_1 + \theta x_2) & \alpha(x_3 + \theta x_4) \\ \gamma\bar{\alpha}(x_3 + \bar{\theta}x_4) & \bar{\alpha}(x_1 + \bar{\theta}x_2) \end{bmatrix}$$

where $\theta = \frac{1+\sqrt{5}}{2}$, $\bar{\theta} = 1 - \bar{\theta}$, $\gamma = i$

$\alpha = 1 + i(1-\theta)$, $\bar{\alpha} = 1 + i(1-\bar{\theta})$

# FIG. 9

| ··· | Data Symbol#M-1 | Pilot Symbol | Data Symbol#1 | Data Symbol#2 | ··· | Data Symbol#M-1 | Pilot Symbol | ··· |
|---|---|---|---|---|---|---|---|---|

1 frame

# FIG. 10

EP 1 983 678 A2

## FIG. 11

$$\frac{1}{\sqrt{2}} \cdot \begin{bmatrix} 1 & e^{j\frac{\pi}{4}} \\ 1 & e^{j\frac{5\pi}{4}} \end{bmatrix}$$

## FIG. 12

$$\frac{1}{\sqrt{2}} \cdot \begin{bmatrix} 1 & 1 \\ 1 & -1 \end{bmatrix}$$

## FIG. 13

$$\frac{1}{\sqrt{2}} \cdot \begin{bmatrix} e^{j\frac{\pi}{4}} & e^{-j\frac{\pi}{4}} \\ e^{j\frac{\pi}{4}} & -e^{-j\frac{\pi}{4}} \end{bmatrix}$$

# FIG. 14

$$\frac{1}{\sqrt{1.25}} \cdot \begin{bmatrix} 0.5 & 1 \\ 1 & -0.5 \end{bmatrix}$$

# FIG. 15

$$\frac{1}{\sqrt{2}} \cdot \begin{bmatrix} e^{j\frac{\pi}{2}} & 1 \\ (\ )^* & e^{-j\frac{\pi}{2}} \cdot (\ )^* \end{bmatrix}$$

# FIG. 16

$$\Pi(i) = (P \cdot \Pi(i-1) + N/4 - 1)_{\text{mod-}N}, \Pi(0) = 0;$$
$$k = F(n) = d_n - N/2$$

# FIG. 17

$$\Pi(i) = 13 \cdot \Pi(i-1) + 511(\mathrm{mod}\ 2048) \text{ and } \Pi(0)=0;$$
$$k = F(n) = d_n - 1024$$

| i | $\Pi(i)$ | $d_n$ | n | k |
|---|---|---|---|---|
| 0 | 0 | | | |
| 1 | 511 | 511 | 0 | −513 |
| 2 | 1010 | 1010 | 1 | −14 |
| 3 | 1353 | 1353 | 2 | 239 |
| 4 | 1716 | 1716 | 3 | 692 |
| 5 | 291 | 291 | 4 | −733 |
| 6 | 198 | | | |
| 7 | 1037 | 1037 | 5 | 13 |
| 8 | 1704 | 1704 | 6 | 680 |
| 9 | 135 | | | |
| 10 | 218 | | | |
| 11 | 1297 | 1297 | 7 | 273 |
| 12 | 988 | 988 | 8 | −36 |
| 13 | 1076 | 1067 | 9 | 43 |
| 14 | 46 | | | |
| 15 | 1109 | 1109 | 10 | 85 |
| 16 | 592 | 592 | 11 | −432 |
| 17 | 15 | | | |
| 18 | 706 | 706 | 12 | −318 |
| ⋮ | ⋮ | ⋮ | ⋮ | ⋮ |
| 2044 | 1676 | 1676 | 1533 | 652 |
| 2045 | 1819 | | | |
| 2046 | 1630 | 1630 | 1534 | 606 |
| 2047 | 1221 | 1221 | 1535 | 197 |

# FIG. 18

| Output | $y(t)$ | $y(t+T)$ |
|--------|--------|----------|
| Tx. #1 | $s_0$ | $-s_1^*$ |
| Tx. #2 | $s_1$ | $s_0^*$ |

# FIG. 19

Antenna#0
Even carrier

Antenna#1
Odd carrier

Freq.

# FIG. 20

Antenna#0    Antenna#1

Even
Symbol

Freq.

Antenna#0

Odd
Symbol

Freq.

Antenna#1

## FIG. 21

1400 Receiver — 1410 Synchronizer — 1420 Demodulator — 1430 Frame Parser — 1440 Multi-Input/Output Decoder — 1450 First Deinterleaver

1460 Linear Pre-Coding Decoder — 1470 Symbol Demapper — 1480 Second Deinterleaver — 1490 Forward Error Correction Decoder — Data

# FIG. 22

Input → | 1462 Serial/ Parallel Converter | → | 1464 First Decoder | → | 1466 Parallel/ Serial Converter | → Output

# FIG. 23

Input → | 1461 Serial/ Parallel Converter | → | 1463 Second Decoder | → | 1465 Parallel/ Serial Converter | → Output

## FIG. 24

$$\frac{1}{\sqrt{2}} \cdot \begin{bmatrix} e^{-j\frac{\pi}{4}} & e^{-j\frac{\pi}{4}} \\ e^{j\frac{\pi}{4}} & -e^{j\frac{\pi}{4}} \end{bmatrix}$$

## FIG. 25

$$\frac{1}{\sqrt{1.25}} \cdot \begin{bmatrix} 0.5 & 1 \\ 1 & -0.5 \end{bmatrix}$$

## FIG. 26

$$\frac{1}{\sqrt{2}} \cdot \begin{bmatrix} e^{-j\frac{\pi}{2}} & (\ )^* \\ 1 & e^{-j\frac{\pi}{2}} \cdot (\ )^* \end{bmatrix}$$

# FIG. 27

Received symbols → | Equalizer |1472 → → | SOVA Trellis Decoder |1474 → Log likelihood ratio

# FIG. 28

De-interleaver → | LDPC Decoder |1492 → | BCH Decoder |1494 → Data

# FIG. 29

EP 1 983 678 A2

# FIG. 30

$$r_{s,i}(k) = h_{s,0,i}(k)s_s(k) + h_{s,1,i}(k)s_{s+1}(k) + n_s(k)$$
$$r_{s+1,i}(k) = -h_{s+1,0,i}(k)s^*_{s+1}(k) + h_{s+1,1,i}(k)s^*_s(k) + n_{s+1}(k)$$

# FIG. 31

$$r_0 = r(t) = h_0 s_0 + h_1 s_1 + n_0$$
$$r_1 = r(t+T) = -h_0 s_1^* + h_1 s_0^* + n_1$$

$$\overline{s}_0 = h_0^* r_0 + h_1 r_1^*$$
$$\overline{s}_1 = h_1^* r_0 - h_0 r_1^*$$

# FIG. 32

Data → Forward Error Correction Encoder (2200) → First Interleaver (2210) → Symbol Mapper (2220) →

→ Linear Pre-Coder (2230) → Second Interleaver (2240) → Frame Builder (2250) → Modulator (2260) → Transmitter (2270) →

# FIG. 33

→ Receiver (2300) → Synchronizer (2310) → Demodulator (2320) → Frame Parser (2330) → First Deinterleaver (2340) →

→ Linear Pre-Coding Decoder (2350) → Symbol Demapper (2360) → Second Deinterleaver (2370) → Forward Error Correction Decoder (2380) → Data

# FIG. 34

```
                    ┌──────────┐
                    │   Start  │
                    └──────────┘
                         │
                         ▼
    ┌─────────────────────────────────────────┐
    │         FEC-encode input data            │──  S2400
    └─────────────────────────────────────────┘
                         │
                         ▼
    ┌─────────────────────────────────────────┐
    │       Interleave encoded data and        │──  S2402
    │   convert interleaved data into symbol data │
    └─────────────────────────────────────────┘
                         │
                         ▼
    ┌─────────────────────────────────────────┐
    │      Perform pre-coding so as to disperse │
    │      input symbol data into several output │──  S2404
    │       symbols in frequency domain        │
    └─────────────────────────────────────────┘
                         │
                         ▼
    ┌─────────────────────────────────────────┐
    │   Perform interleaving such that output symbol │──  S2406
    │  is not subjected to same frequency selective fading │
    └─────────────────────────────────────────┘
                         │
                         ▼
    ┌─────────────────────────────────────────┐
    │   Multi-input/output encode interleaved symbol │──  S2408
    └─────────────────────────────────────────┘
                         │
                         ▼
    ┌─────────────────────────────────────────┐
    │ Modulate frame data and transmit the modulated data │──  S2410
    └─────────────────────────────────────────┘
                         │
                         ▼
                    ┌──────────┐
                    │    End   │
                    └──────────┘
```

# FIG. 35

```
                    ┌─────────────┐
                    │    Start    │
                    └─────────────┘
                           │
                           ▼
        ┌──────────────────────────────────────┐
        │  Demodulate received data to frame data │─── S2500
        └──────────────────────────────────────┘
                           │
                           ▼
        ┌──────────────────────────────────────┐
        │ Multi-input/output decode demodulated data │─── S2502
        └──────────────────────────────────────┘
                           │
                           ▼
        ┌──────────────────────────────────────┐
        │ Perform deinterleaving by inverse process of │─── S2504
        │  the interleaving method and restore data    │
        └──────────────────────────────────────┘
                           │
                           ▼
        ┌──────────────────────────────────────┐
        │ Perform inverse process of pre-coding process and │─── S2506
        │ restore symbol data dispersed in frequency domain │
        └──────────────────────────────────────┘
                           │
                           ▼
        ┌──────────────────────────────────────┐
        │ Demap symbol to bit data and deinterleave bit data │─── S2508
        └──────────────────────────────────────┘
                           │
                           ▼
        ┌──────────────────────────────────────┐
        │         FEC-decode input data          │─── S2510
        └──────────────────────────────────────┘
                           │
                           ▼
                    ┌─────────────┐
                    │     End     │
                    └─────────────┘
```

**EP 1 983 678 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020070038308